# EUROPEAN PATENT SPECIFICATION

(11) **EP 4 113 605 B1**
(45) Date of publication and mention of the grant of the patent: **08.04.2026**
(21) Application number: 21183453.6
(22) Date of filing: 02.07.2021
(51) Int. Cl.: H01L 25/07, H01L 23/00, H01L 23/482, H01L 23/373

(54) **POWER SEMICONDUCTOR MODULE ARRANGEMENT**
LEISTUNGSHALBLEITERMODULANORDNUNG
AGENCEMENT DE MODULE D'ALIMENTATION À SEMI-CONDUCTEUR

(43) Date of publication of application: 04.01.2023
(73) Proprietor: Infineon Technologies AG, 85579 Neubiberg (DE)
(72) Inventor: MÜLLER, Christian Robert, 97421 Schweinfurt (DE); DIETZINGER, Christoph, 86859 Igling (DE); PHILIPPOU, Alexander, 81739 München (DE); STOIB, Benedikt, 83620 Feldkirchen-Westerham (DE)
(74) Representative: Westphal, Mussgnug & Partner, Patentanwälte mbB

(56) References cited:
- EP-A1- 3 324 434
- US-A1- 2012 175 688
- US-A1- 2019 109 225
- US-B2- 10 727 209
- US-B2- 8 294 208

## Description

### TECHNICAL FIELD

The instant disclosure relates to a power semiconductor module arrangement, in particular to a power semiconductor module arrangement comprising at least two switching devices.

### BACKGROUND

Power semiconductor module arrangements often include at least one semiconductor substrate arranged in a housing. A semiconductor arrangement including a plurality of semiconductor elements (e.g., two IGBTs or MOSETs in a half-bridge configuration) is arranged on each of the at least one substrate. Each substrate usually comprises a substrate layer (e.g., a ceramic layer), a first metallization layer deposited on a first side of the substrate layer and (optionally) a second metallization layer deposited on a second side of the substrate layer. The semiconductor elements are mounted, for example, on the first metallization layer. The second metallization layer may optionally be attached to a base plate. The semiconductor devices are usually mounted onto the semiconductor substrate by soldering or sintering techniques.

The semiconductor elements comprise several chip metallizations, e.g., chip pad metallizations. Chip (pad) metallizations of one semiconductor element can be electrically coupled to chip (pad) metallizations of other semiconductor elements or to the first metallization layer by means of electrical connections such as, e.g., bonding wires or ribbons. Such electrical connections are formed using appropriate tools. The tools that are used to form electrical connections, however, may unintentionally damage other structures (e.g., other chip metallizations) formed on the semiconductor elements.

Document EP 3 324 434 A1 discloses a semiconductor assembly including a first semiconductor chip, a pedestal and a first bonding wire. The first semiconductor chip is disposed on a substrate and includes a first semiconductor body, a first chip electrode and a second chip electrode. The pedestal is disposed on the substrate and includes a second semiconductor body, a first pedestal electrode and a second pedestal electrode. The second pedestal electrode is electrically connected to the second chip electrode. The first bonding wire is, at a first bonding location, bonded to the first chip electrode and, at a second bonding location, to the first pedestal electrode. The second semiconductor body comprises a series circuit with two diodes connected back-to-back between the first pedestal electrode and the second pedestal electrode, so that for each polarity of an electrical voltage applied between the first chip electrode and the second chip electrode, the magnitude of a breakdown voltage of the second semiconductor body is greater than the magnitude of a breakdown voltage of the first semiconductor body.

Document US 2019/109225 A1 discloses a MOSFET device integrated in a body of semiconductor material of a first conductivity type accommodating a body region, of a second conductivity type, and a source region, of the first conductivity type. A gate region extends over the top surface of the body; a source pad extends over the first top surface and is electrically coupled to the source region, a first gate pad extends over the first main surface, alongside the source pad, and is electrically coupled to the gate region; a drain pad extends over the rear surface and is electrically coupled to the body; a second gate pad extends over the rear surface, alongside the drain pad; and a conductive via extends through the body and electrically couples the gate region to the second gate pad.

Document US 8 294 208 B2 discloses a power semiconductor device which includes a gate contact on one surface thereof connected to a gate bus on another opposing surface thereof using a conductive body extending through a via between the two surfaces of the device.

Document US 10 727 209 B2 discloses a semiconductor device including a first semiconductor element, a first element insulating part, and an insulating sealing member. The first semiconductor element includes a first semiconductor chip and a first chip electrode electrically connected to the first semiconductor chip. The first semiconductor chip has a first surface crossing a first direction, a second surface crossing the first direction and distant from the first surface, and a third surface between the first and second surfaces. The first chip electrode is disposed on the first surface. The first element insulating part includes a first portion and a second portion continuous to the first portion. The insulating sealing member includes a third portion and a fourth portion continuous to the third portion. The first portion is between the first surface and the third portion, and the second portion is between the third surface and the fourth portion.

Document US 2012/175688 A1 discloses a semiconductor package including a semiconductor device having electrodes on opposite major surfaces connectable to a planar support surface without a bondwire and a control electrode disposed in a corner position. The structure comprises a semiconductor device having a first major surface including a first electrode and a second major surface including a second electrode and a control electrode, wherein the control electrode is disposed in a corner of the second major surface, and wherein the first electrode, the second electrode, and the control electrode are electrically connectable to a planar support surface without a bondwire. The pads of the device may be arranged in a balanced grid.

There is a need for a power semiconductor module arrangement in which damages caused by tools while forming electrical connections are avoided or at least reduced.

### SUMMARY

There is provided a power semiconductor module arrangement according to claim 1.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement, not forming part of the present invention but useful for understanding it.
Figure 2 is a top view of a power semiconductor module arrangement, according to the present invention.
Figure 3 schematically illustrates a section of the power semiconductor module arrangement of Figure 2, according to the present invention.
Figure 4, including Figures 4A and 4B, schematically illustrates a first semiconductor die and a second semiconductor die of a power semiconductor module arrangement according to the present invention.
Figure 5 is a top view of a power semiconductor module arrangement according to the present invention.
Figure 6, including Figures 6A and 6B, schematically illustrates a first semiconductor die and a second semiconductor die of a power semiconductor module arrangement according to the present invention.
Figure 7, including Figures 7A and 7B, schematically illustrates a first semiconductor die and a second semiconductor die of a power semiconductor module arrangement according to the present invention.
Figure 8, including Figures 8A and 8B, schematically illustrates a first semiconductor die and a second semiconductor die of a power semiconductor module arrangement according to the present invention.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not necessarily require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor die has electrically connectable pads and includes at least one semiconductor element with electrodes.

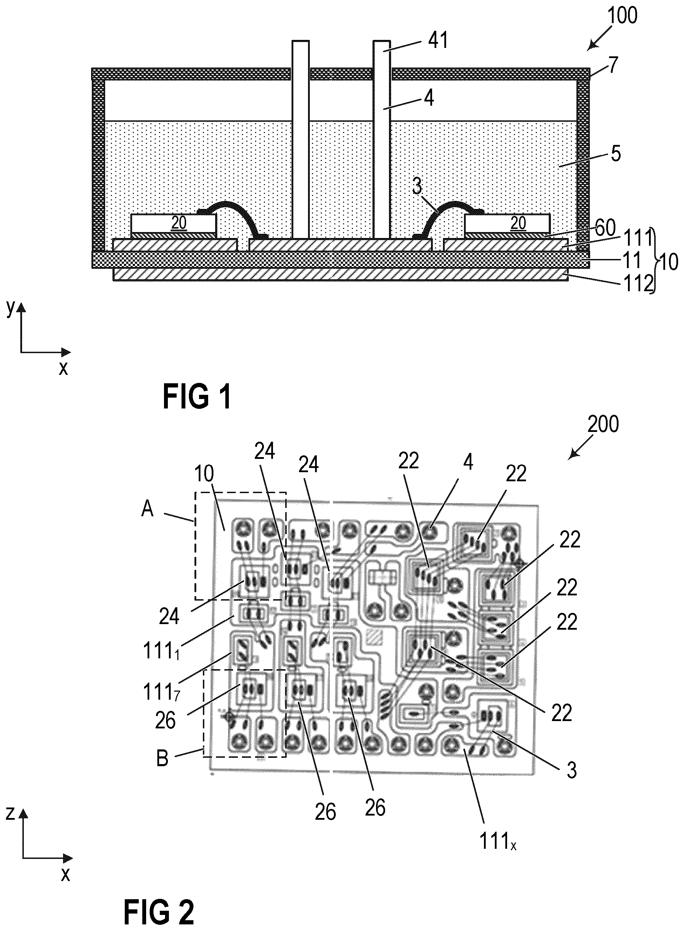

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AlN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a base surface of the housing 7, while the housing 7 itself solely comprises sidewalls and a cover. This, however, is only an example. It is also possible that the housing 7 further comprises a base surface and the substrate 10 is arranged on the base surface inside the housing 7. According to another example (not specifically illustrated), the substrate 10 may be mounted on a base plate. The base plate may form a bottom of the housing 7. In some power semiconductor module arrangements 100, more than one substrate 10 is arranged within the same housing 7.

One or more semiconductor dies 20 may be arranged on the at least one substrate 10. Each of the semiconductor dies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor dies 20 may form a semiconductor arrangement on the substrate 10. In Figure 1, only two semiconductor dies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor dies 20 may be mounted to the same or to different sections of the first metallization layer 111. Different sections of the first metallization layer may have no electrical connection or may be electrically connected to one or more other sections using electrical connections 3 such as, e.g., bonding wires. Semiconductor dies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor dies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end, while a second end 41 of the terminal elements 4 protrudes out of the housing 7. The terminal elements 4 may be electrically contacted from the outside at their second end 41. Such terminal elements 4, however, are only an example. The components inside the housing 7 may be electrically contacted from outside the housing 7 in any other suitable way. For example, terminal elements 4 may be arranged closer to or adjacent to the sidewalls of the housing 7. It is also possible that terminal elements 4 protrude vertically or horizontally through the sidewalls of the housing 7. It is even possible that terminal elements 4 protrude through a ground surface of the housing 7. The first end of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end of a terminal element 4 may also be electrically coupled to the substrate 10 via one or more electrical connections 3, for example.

The power semiconductor module arrangement 100 generally further includes an encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their second ends 41, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged inside the housing 7, from certain environmental conditions and mechanical damage. It is generally also possible to omit the housing 7 and solely protect the substrate 10 and any components mounted thereon with an encapsulant 5. In this case, the encapsulant 5 may be a rigid material, for example.

Now referring to Figure 2, a top view of a power semiconductor module arrangement 200 is schematically illustrated. The power semiconductor module arrangement 200 comprises a substrate 10, similar to the substrate 10 that has been described with respect to Figure 1 above. The first metallization layer 111 in the example of Figure 2 comprises a plurality x of different sections 111ₓ. A plurality of semiconductor dies 22, 24, 26 is arranged on the substrate 10. Three first semiconductor dies 24 are arranged on one section 111₁ of the first metallization layer 111, three second semiconductor dies 26 are arranged on another section 111₇ of the first metallization layer 111, and a plurality of third semiconductor dies 22 are arranged on even further sections of the first metallization layer 111. The first semiconductor dies 24 each include a switching device, the second semiconductor dies 26 each include a switching device, and the third semiconductor dies 22 each include a diode in the example of Figure 2. In this specific example, the first semiconductor dies 24 form high side switches, and the second semiconductor dies 26 form low side switches. That is, the first semiconductor dies 24 each include a load path between a first load terminal and a second load terminal, and a control terminal, and the second semiconductor dies 26 each include a load path between a first load terminal and a second load terminal and a control terminal. The first load terminals of the first semiconductor dies 24 are coupled to a first potential (e.g., positive potential), the second load terminals of the first semiconductor dies 24 are coupled to the first load terminals of the second semiconductor dies 26, and the second load terminals of the second semiconductor dies 26 are coupled to a second potential (e.g., negative potential or ground). The first semiconductor dies 24 and the second semiconductor dies 26 in this example are arranged in a half-bridge configuration. The third semiconductor dies 22 form rectifier diodes, for example. A plurality of terminal elements 4 is also mounted on different sections of the first metallization layer 111. The different semiconductor dies 22, 24, 26 are electrically coupled to each other or to different sections of the first metallization layer 111 by means of electrical connections 3, as has been described above.

In the embodiment illustrated in Figure 2, the plurality of first semiconductor dies 24, the plurality of second semiconductor dies 26 and the plurality of third semiconductor dies 22 form a three-phase power inverter. In three-phase power inverters, the first semiconductor dies 24 and the second semiconductor dies 26 are often implemented identically with regard to the size and position of different chip (pad) metallizations. Chip (pad) metallizations in accordance with the present invention will be described further below.

A power semiconductor module arrangement 200 comprising three first semiconductor dies 24 and three second semiconductor dies 26 is only any example. The power semiconductor module arrangement 200 generally can comprise any number of first semiconductor dies 24 and second semiconductor dies 26. According to one example, the number of first semiconductor dies 24 equals the number of second semiconductor dies 26. The power semiconductor module arrangement 200 may also include any suitable number of third semiconductor dies 22 and, optionally, any other semiconductor devices.

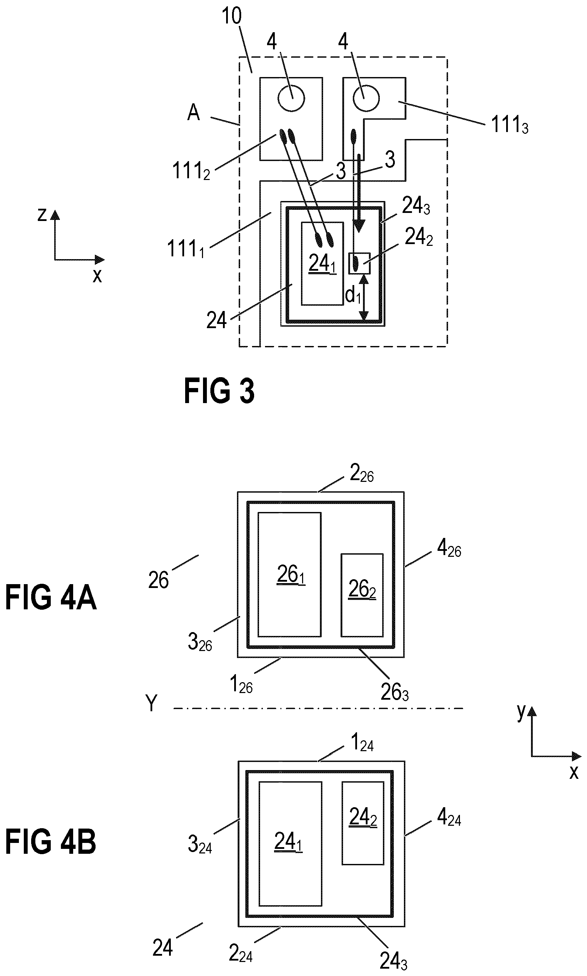

Now referring to Figure 3, a section A of the power semiconductor module arrangement 200 of Figure 2 is illustrated in greater detail. This section A includes part of a first section 111₁ of the first metallization layer 111, a second section 111₂ of the first metallization layer 111, and a third section 111₃ of the first metallization layer 111. A first semiconductor die 24 is mounted on the first section 111₁ and terminal elements 4 are mounted on each of the second section 111₂ and the third section 111₃. The first semiconductor die 24 comprises a first chip (pad) metallization 24₁, a second chip (pad) metallization 24₂ and a third chip metallization 24₃, arranged on a top side of the first semiconductor die 24. The top side of the first semiconductor die 24 is a side of the first semiconductor die 24 which faces away from the substrate 10. The first semiconductor die 24, as has been described above, includes a switching element such as, e.g., an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable switching element. The first load terminal of the first semiconductor die 24 may be connected to a further chip (pad) metallization (not visible in Figure 3) formed on a bottom side of the first semiconductor die 24, and mechanically and electrically coupled to the first section 111₁. The second load terminal of the first semiconductor die 24 may be connected to the first chip (pad) metallization 24₁, and the control terminal of the first semiconductor die 24 may be connected to the second chip (pad) metallization 24₂.

The first chip (pad) metallization 24₁ is electrically coupled to the second section 111₂ of the first metallization layer 111 by means of electrical connections 3 (e.g., bonding wires). The second section 111₂ can be electrically contacted from the outside of the power semiconductor module arrangement 200 by means of terminal element 4. The second chip (pad) metallization 24₂ is electrically coupled to the third section 111₃ by means of another electrical connection 3. The third section 111₃ can be electrically contacted from the outside of the power semiconductor module arrangement 200 by means of terminal element 4. The first chip (pad) metallization 24₁ and the second chip (pad) metallization 24₂ are extensive metallizations that have a square or rectangular cross-section, in order to provide an area that is large enough to form a connection to one or more electrical connections 3. The third chip metallization 24₃ is an elongated metallization extending along the edges of the first semiconductor die 24. The third chip metallization 24₃ forms a termination field plate electrode. Such termination field plates are often used in order to spread the electric fields occurring during the use of the first semiconductor die 24 more uniformly in the edge regions. In this way, the breakdown voltage of the device can be increased. According to one example, the third chip metallization 24₃ is covered by a thin layer of imide.

The electrical connections 3 are formed using appropriate tools. The tools that are used to form electrical connections 3, however, may unintentionally damage other structures (e.g., other chip metallizations) formed on the semiconductor elements. For example, a tool may scratch the surface of the first semiconductor die 24 close to the second chip (pad) metallization 24₂, after forming a mechanical connection between the electrical connection 3 and the second chip (pad) metallization 24₂. In the arrangement illustrated in Figure 3, the electrical connection 3 is first mounted to the third section 111₃ with a first end, and is subsequently mounted to the first semiconductor die 24 with a second end. This direction is chosen, because the terminal element 4 restricts the movement of the tool in the other direction. The mounting direction is indicated by the arrow in Figure 3. The electrical connection 3 is usually cut from a continuous wire or ribbon. In particular, the wire or ribbon may be cut after securely attaching the second end of the electrical connection 3. For this reason, the tool usually cannot be immediately lifted from the first semiconductor die 24, but instead moves further close to the top surface of the respective first semiconductor die 24 for a certain distance. A distance di between the second chip (pad) metallization 24₂ and the third chip metallization 24₃ in the direction of movement of the mounting tool, therefore, may be chosen to be large enough in order to prevent the tool from damaging the third chip metallization 24₃. The tool may already have lifted off the first semiconductor die 24 far enough by the time it crosses the third chip metallization 24₃, in order to prevent it from scratching and thereby damaging the third chip metallization 24₃. Similar problems may arise concerning the other ones of the first semiconductor dies 24 as well as the second semiconductor dies 26 (see, e.g., section B as indicated in Figure 2).

The layout of the chip metallizations on a top surface of the semiconductor dies 24, 26 therefore may be chosen in such a way that damages of any (metallic) structures on a top surface of the semiconductor dies 24, 26 by means of any tools that are used to form electrical connections 3 can be reduced or even avoided. According to one example, it is possible to use one and the same layout for as many semiconductor dies 24, 26 as possible, instead of designing individual layouts for each of the different semiconductor dies 24, 26.

According to the present invention, the first chip metallization 24₁, the second chip metallization 24₂ and the third chip metallization 24₃ of the first semiconductor dies 24 of a power semiconductor module arrangement 200 form a first pattern, and the first chip metallization 26₁, the second chip metallization 26₂ and the third chip metallization 26₃ of the second semiconductor dies 26 of a power semiconductor module arrangement 200 form a second pattern, the second pattern being different from the first pattern. This is schematically illustrated in Figure 4, where Figure 4A schematically illustrates a second semiconductor die 26, and Figure 4B schematically illustrates a first semiconductor die 24.

The first semiconductor die 24 in this example has a square cross-section, but may also have a rectangular cross-section instead. The third chip metallization 24₃ is a circumferential metallization that extends continuously along all of the four edges of the first semiconductor die 24. The first chip metallization 24₁ has a rectangular cross-section and extends between a first side 1₂₄ of the first semiconductor die 24 and a second side 2₂₄ of the first semiconductor die 24, opposite the first side 1₂₄. The first chip metallization 24₁ is arranged closer to a third side 3₂₄ of the first semiconductor die 24 than to a fourth side 4₂₄ of the first semiconductor die 24, opposite the third side 3₂₄. The first chip metallization 24₁, therefore, is arranged on one half of the first semiconductor die 24. The second chip metallization 24₂ is arranged on the second half of the first semiconductor die 24. The second chip metallization 24₂ also has a rectangular cross-section, extends between the first side 1₂₄ and the second side 2₂₄, and is arranged closer to the fourth side 4₂₄ than to the third side 3₂₄. The second chip metallization 24₂ has a smaller cross-section than the first chip metallization 24₁ and is arranged closer to the first side 1₂₄ than to the second side 2₂₄. In particular, a length of the second chip metallization 24₂ in a horizontal direction y perpendicular to the first side 1₂₄ and the second side 2₂₄ is shorter than a length of the first chip metallization 24₁ in the same direction y. In this way, a corner formed between the second side 2₂₄ and the fourth side 4₂₄ inside of the third chip metallization 24₃ is not covered by either the first chip metallization 24₁ or the second chip metallization 24₂ or by any other metallization. When an electrical connection 3 is formed such that it ends on the first semiconductor chip 24 (e.g., on the second chip metallization 24₂), as has been described with respect to Figure 3 above, the area in this corner in which no metallization is formed functions as a lift-off area for the (bonding) tool. Damages to the third chip metallization 24₃ can be avoided or at least reduced in this way.

When the first semiconductor die 24 is mirrored along an axis of symmetry Y, this results in the second semiconductor die 26 (see Figure 4A). That is, the first pattern of the first semiconductor die 24 is mirror symmetric with the second pattern of the second semiconductor die 26. The first pattern and the second pattern, however, are not superimposable. This means that the first pattern and the second pattern cannot be exactly aligned with each other. The first pattern and the second pattern, therefore are chiral patterns.

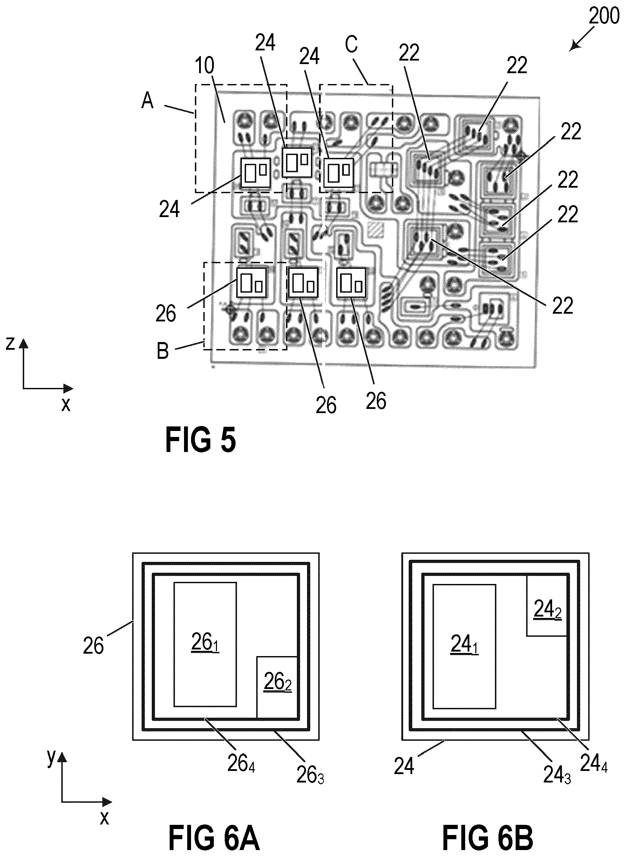

Now referring to Figure 5, a power semiconductor module arrangement 200 according to one embodiment of the present invention is schematically illustrated. The first semiconductor dies 24 in this example comprise the first, second and third chip metallizations 24₁, 24₂, 24₃ arranged in the first pattern, and the second semiconductor dies 26 comprise the first, second and third chip metallizations 26₁, 26₂, 26₃ arranged in the second pattern as have been described with respect to Figure 4 above. The first semiconductor dies 24 and the second semiconductor dies 26 of the power semiconductor module arrangement 200, therefore, are realized using only two different patterns. Generally, however, it is also possible to realize one or more of the first and/or second semiconductor dies 24, 26 using even further (chiral) patterns. In order to keep the design of the power semiconductor module arrangement 200 as simple and cost-effective as possible, however, as few different patterns as possible may be used.

By arranging the second chip metallization 24₂, 26₂ in one corner of the respective first or second semiconductor die 24, 26, the distance d1 between the second chip metallization 24₂, 26₂ and the respective third chip metallization 24₃, 26₃ in a direction of movement of a (bonding) tool is still large enough, even if an overall size of the first and second semiconductor dies 24, 26 is further reduced.

According to further embodiments of the present invention, it is also possible that further structures are arranged on a top surface of the first and second semiconductor dies 24, 26. As is illustrated in Figures 6A and 6B, for example, it is also possible to arrange a so-called gate runner 24₄, 26₄ on a top surface of the first and second semiconductor dies 24, 26. A transistor device generally comprises a plurality of individual transistor cells formed in the semiconductor body of the transistor device. Each individual transistor cell usually comprises a gate electrode. A gate runner 24₄, 26₄ electrically couples the plurality of gate electrodes to the gate pad (e.g., second chip metallization 24₂, 26₂). The gate runner 24₄, 26₄, similar to the third metallization region 24₃, 26₃, may be a circumferential metallization region extending along the four different sides of the respective semiconductor die 24, 26. The third chip metallization 24₃, 26₃ is arranged between the gate runner 24₄, 26₄ and the edges of the respective semiconductor die 24, 26.

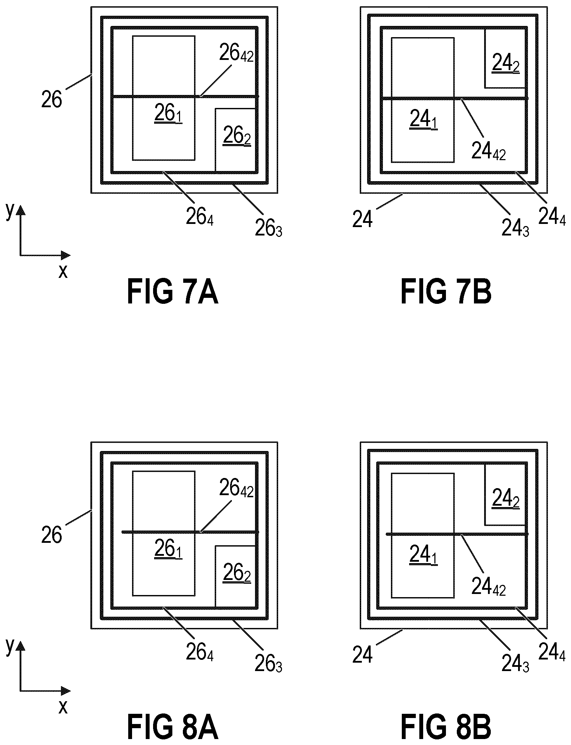

As is illustrated in Figures 7 and 8, it is further possible to form at least one so-called gate finger 24₄₂, 26₄₂ on a top surface of the first and second semiconductor dies 24, 26. Such a gate finger 24₄₂, 26₄₂ may be configured to more uniformly distribute a gate signal to the individual transistor cells of the semiconductor die 24, 26. A gate finger 24₄₂, 26₄₂ may continuously extend between two opposite sides of an essentially square or rectangular gate runner 24₄, 26₄, as is illustrated in Figures 7A and 7B. According to another example, the gate finger 24₄₂, 26₄₂ may contact only one side of the gate runner 24₄, 26₄, but not the opposite side of the 24₄, 26₄. This is schematically illustrated in Figures 8A and 8B. The gate finger 24₄, 26₄ may extend centrally on the top surface of the semiconductor die 24, 26 such that one half of the semiconductor die 24, 26 is arranged on one side of the gate finger 24₄, 26₄, and another half of the semiconductor die 24, 26 is arranged on the other side of the gate finger 24₄, 26₄. This, however, is only an example. One or more gate fingers may be arranged in any suitable positions on the top surface of the semiconductor dies 24, 26.

Summarizing the above, a power semiconductor module arrangement 200 according to the present invention comprises at least one first semiconductor die 24 implemented as a switching device and mounted on the first metallization layer 111 of a substrate 10, and at least one second semiconductor die 26 implemented as a switching device and mounted on the first metallization layer 111 of the substrate 10. Each of the at least one first semiconductor die 24 comprises a first chip metallization 24₁, a second chip metallization 24₂ and a third chip metallization 24₃ arranged on a top side of the respective first semiconductor die 24, wherein a top side of a first semiconductor die 24 is a side of the first semiconductor die 24 that faces away from the substrate 10. Each of the at least one second semiconductor die 26 comprises a first chip metallization 26₁, a second chip metallization 26₂ and a third chip metallization 26₃ arranged on a top side of the respective second semiconductor die 26, wherein a top side of a second semiconductor die 26 is a side of the second semiconductor die 26 that faces away from the substrate 10. The first chip metallization 24₁, the second chip metallization 24₂ and the third chip metallization 24₃ of at least one of the at least one first semiconductor die 24 are arranged on the top side of the respective first semiconductor die 24 forming a first pattern, and the first chip metallization 26₁, the second chip metallization 26₂ and the third chip metallization 26₃ of each of the at least one second semiconductor die 26 are arranged on the top side of the respective second semiconductor die 26 forming a second pattern, wherein the first pattern and the second pattern are chiral patterns.

## Claims

1. A power semiconductor module arrangement (200) comprising:
a substrate (10) comprising a dielectric insulation layer (11), and a first metallization layer (111) arranged on a first side of the dielectric insulation layer (11);
at least one first semiconductor die (24) implemented as a switching device and mounted on the first metallization layer (111) of the substrate (10); and
at least one second semiconductor die (26) implemented as a switching device and mounted on the first metallization layer (111) of the substrate (10), wherein
each of the at least one first semiconductor die (24) comprises a first chip metallization (24₁), a second chip metallization (24₂) and a third chip metallization (24₃) arranged on a top side of the respective first semiconductor die (24), wherein a top side of a first semiconductor die (24) is a side of the first semiconductor die (24) that faces away from the substrate (10),
each of the at least one second semiconductor die (26) comprises a first chip metallization (26₁), a second chip metallization (26₂) and a third chip metallization (26₃) arranged on a top side of the respective second semiconductor die (26), wherein a top side of a second semiconductor die (26) is a side of the second semiconductor die (26) that faces away from the substrate (10),
the first chip metallization (24₁), the second chip metallization (24₂) and the third chip metallization (24₃) of each of the at least one first semiconductor die (24) form a first pattern on the top side of the respective first semiconductor die (24),
the first chip metallization (26₁), the second chip metallization (26₂) and the third chip metallization (26₃) of each of the at least one second semiconductor die (26) form a second pattern on the top side of the respective second semiconductor die (26), the second pattern being different from the first pattern,
the first pattern and the second pattern are chiral patterns,
the first chip metallization (24₁) and the second chip metallization (24₂) of the at least one first semiconductor die (24) are extensive metallizations being rectangular in a top view, and the third chip metallization (24₃) of the at least one first semiconductor die (24) is a circumferential metallization extending along an edge of the respective first semiconductor die (24),
the first chip metallization (26₁) and the second chip metallization (26₂) of the at least one second semiconductor die (26) are extensive metallizations being rectangular in a top view, and the third chip metallization (26₃) of the at least one second semiconductor die (26) is a circumferential metallization extending along an edge of the respective second semiconductor die (26),
the third chip metallization (24₃) of each of the at least one first semiconductor die (24) forms a termination field plate electrode,
the third chip metallization (26₃) of each of the at least one second semiconductor die (26) forms a termination field plate electrode,
each of the at least one first semiconductor die (24) is square or a rectangular in a top view,
the third chip metallization (24₃) is a circumferential metallization extending continuously along all of the four edges of the respective first semiconductor die (24),
the first chip metallization (24₁) is arranged in a first half of the first semiconductor die (24), extends between a first side (1₂₄) of the first semiconductor die (24) and a second side (2₂₄) of the first semiconductor die (24), opposite the first side (124),
the first chip metallization (24₁) is arranged closer to a third side (3₂₄) of the first semiconductor die (24) than to a fourth side (4₂₄) of the first semiconductor die (24), opposite the third side (3₂₄),
the second chip metallization (24₂) is arranged on a second half of the first semiconductor die (24), extending between the first side and the second side of the first semiconductor die (24), and being arranged closer to the fourth side than to the third side of the first semiconductor die (24),
the second chip metallization (24₂) is smaller than the first chip metallization (24₁) and is arranged closer to the first side than to the second side of the first semiconductor die (24), thereby leaving a corner of the first semiconductor die (24) formed between the second side (2₂₄) and the fourth side (4₂₄) of the first semiconductor die (24) inside the third chip metallization (24₃) uncovered by either the first chip metallization (24₁) or the second chip metallization (24₂) or by any other metallization,
the first pattern of the at least one first semiconductor die (24) is mirror symmetric with the second pattern of the at least one second semiconductor die (26) with respect to an axis of symmetry (Y), and
the first pattern and the second pattern are not superimposable and cannot be exactly aligned with each other.

2. The power semiconductor module arrangement (200) of claim 1, wherein
each of the at least one first semiconductor die (24) comprises a load path between a first load terminal and a second load terminal, and a control terminal, wherein the second load terminal of each of the at least one first semiconductor dies (24) is connected to the respective first chip metallization (24₁), and the control terminal of each of the at least one first semiconductor die (24) is connected to the respective second chip metallization (24₂), and
each of the at least one second semiconductor dies (26) comprises a load path between a first load terminal and a second load terminal, and a control terminal, wherein the second load terminal of each of the at least one second semiconductor dies (26) is connected to the respective first chip metallization (26₁), and the control terminal of each of the at least one second semiconductor die (26) is connected to the respective second chip metallization (26₂).

3. The power semiconductor module arrangement (200) of claim 1 or 2, wherein the first metallization layer (111) is a structured layer comprising a plurality of different sections (111ₓ), wherein the at least one first semiconductor die (24) is arranged on a first section (111₁) of the first metallization layer (111) and the at least one second semiconductor die (26) is arranged on another section (111₇) of the first metallization layer (111).

4. The power semiconductor module arrangement (200) of claim 3, wherein
the first chip metallizations (24₁) of each of the at least one first semiconductor die (24) are electrically coupled to a second section (111₂) of the first metallization layer (111) by means of at least one electrical connection (3),
the second chip metallizations (24₂) of each of the at least one first semiconductor die (24) are electrically coupled to a third section (111₃) of the first metallization layer (111) by means of at least one electrical connection (3).

5. The power semiconductor module arrangement (200) of claim 4, wherein each of the at least one electrical connection (3) comprises a bonding wire or bonding ribbon.

6. The power semiconductor module arrangement (200) of any of claims 1 to 5, wherein each of the first semiconductor dies (24) and each of the second semiconductor dies (26) comprises an Insulated-Gate Bipolar Transistor, IGBT, a Metal-Oxide-Semiconductor Field-Effect Transistor, MOSFET, a Junction Field-Effect Transistor, JFET, or a High-Electron-Mobility Transistor, HEMT.

7. The power semiconductor module arrangement (200) of any of the preceding claims, wherein
each of the at least one first semiconductor die (24) and each of the at least one second semiconductor die (26) comprises a plurality of individual transistor cells formed in a semiconductor body of the respective first or second semiconductor die (24, 26), wherein each individual transistor cell comprises a gate electrode,
each of the at least one first semiconductor die (24) and each of the at least one second semiconductor die (26) further comprises a gate runner (24₄, 26₄) that electrically couples the plurality of gate electrodes to the respective second chip metallization (24₂, 26₂),
the gate runner (24₄, 26₄) is a circumferential metallization region extending along the four different sides of the respective first or second semiconductor die (24, 26), and
the respective third chip metallization (24₃, 26₃) is arranged between the gate runner (24₄, 26₄) and the edges of the respective first or second semiconductor die (24, 26).

8. The power semiconductor module arrangement (200) of claim 7, wherein each of the at least one first semiconductor die (24) and each of the at least one second semiconductor die (26) further comprises at least one gate finger (24₄₂, 26₄₂) arranged on the top surface of the respective first or second semiconductor die (24, 26), wherein the at least one a gate finger (24₄₂, 26₄₂) is configured to more uniformly distribute a control signal to the individual transistor cells of the respective first or second semiconductor die (24, 26).

9. The power semiconductor module arrangement (200) of claim 8, wherein each of the at least one circumferential gate runner (24₄, 26₄) has an essentially square or rectangular shape, and wherein each of the at least one gate finger (24₄₂, 26₄₂) continuously extends between two opposite sides of the gate runner (24₄, 26₄).

10. The power semiconductor module arrangement (200) of claim 8, wherein each of the at least one circumferential gate runner (24₄, 26₄) has an essentially square or rectangular shape, and wherein each of the at least one gate finger (24₄₂, 26₄₂) contacts only one side of the gate runner (24₄, 26₄), but not the opposite side of the gate runner (24₄, 26₄).

## Patentansprüche

1. Leistungshalbleitermodulanordnung (200), umfassend:
ein Substrat (10), das eine dielektrische Isolationsschicht (11) und eine erste Metallisierungsschicht (111) umfasst, die auf einer ersten Seite der dielektrischen Isolationsschicht (11) angeordnet ist;
mindestens einen ersten Halbleiter-Die (24), der als eine Schaltvorrichtung implementiert und auf der ersten Metallisierungsschicht (111) des Substrats (10) montiert ist; und
mindestens einen zweiten Halbleiter-Die (26), der als eine Schaltvorrichtung implementiert und auf der ersten Metallisierungsschicht (111) des Substrats (10) montiert ist, wobei
jeder des mindestens einen ersten Halbleiter-Dies (24) eine erste Chipmetallisierung (24₁), eine zweite Chipmetallisierung (24₂) und eine dritte Chipmetallisierung (24₃), die auf einer Oberseite des jeweiligen ersten Halbleiterchips (24) angeordnet sind, umfasst, wobei eine Oberseite eines ersten Halbleiter-Dies (24) eine Seite des ersten Halbleiter-Dies (24) ist, die von dem Substrat (10) weg weist,
jeder des mindestens einen zweiten Halbleiter-Dies (26) eine erste Chipmetallisierung (26₁), eine zweite Chipmetallisierung (26₂) und eine dritte Chipmetallisierung (26₃), die auf einer Oberseite des jeweiligen zweiten Halbleiter-Dies (26) angeordnet sind, umfasst, wobei eine Oberseite eines zweiten Halbleiter-Dies (26) eine Seite des zweiten Halbleiter-Dies (26) ist, die von dem Substrat (10) weg weist,
die erste Chipmetallisierung (24₁), die zweite Chipmetallisierung (24₂) und die dritte Chipmetallisierung (24₃) jedes des mindestens einen ersten Halbleiter-Dies (24) ein erstes Muster auf der Oberseite des jeweiligen ersten Halbleiter-Dies (24) bilden,
die erste Chipmetallisierung (26₁), die zweite Chipmetallisierung (26₂) und die dritte Chipmetallisierung (26₃) jedes des mindestens einen zweiten Halbleiter-Dies (26) ein zweites Muster auf der Oberseite des jeweiligen zweiten Halbleiter-Dies (26) bilden, wobei sich das zweite Muster von dem ersten Muster unterscheidet,
das erste Muster und das zweite Muster chirale Muster sind,
die erste Chipmetallisierung (24₁) und die zweite Chipmetallisierung (24₂) des mindestens einen ersten Halbleiter-Dies (24) ausgedehnte Metallisierungen sind, die in einer Draufsicht rechteckig sind, und die dritte Chipmetallisierung (24₃) des mindestens einen ersten Halbleiter-Dies (24) eine umlaufende Metallisierung ist, die sich entlang einer Kante des jeweiligen ersten Halbleiter-Dies (24) erstreckt,
die erste Chipmetallisierung (26₁) und die zweite Chipmetallisierung (26₂) des mindestens einen zweiten Halbleiter-Dies (26) ausgedehnte Metallisierungen sind, die in einer Draufsicht rechteckig sind, und die dritte Chipmetallisierung (26₃) des mindestens einen zweiten Halbleiter-Dies (26) eine umlaufende Metallisierung ist, die sich entlang einer Kante des jeweiligen zweiten Halbleiter-Dies (26) erstreckt,
die dritte Chipmetallisierung (24₃) jedes des mindestens einen ersten Halbleiter-Dies (24) eine Abschlussfeldplattenelektrode bildet,
die dritte Chipmetallisierung (26₃) jedes des mindestens einen zweiten Halbleiter-Dies (26) eine Abschlussfeldplattenelektrode bildet,
jeder des mindestens einen ersten Halbleiter-Dies (24) in einer Draufsicht quadratisch oder rechteckig ist,
die dritte Chipmetallisierung (24₃) eine umlaufende Metallisierung ist, die sich kontinuierlich entlang aller vier Kanten des jeweiligen ersten Halbleiter-Dies (24) erstreckt,
die erste Chipmetallisierung (24₁) in einer ersten Hälfte des ersten Halbleiter-Dies (24) angeordnet ist, sich zwischen einer ersten Seite (1₂₄) des ersten Halbleiter-Dies (24) und einer zweiten Seite (2₂₄) des ersten Halbleiter-Dies (24) gegenüber der ersten Seite (1₂₄) erstreckt,
die erste Chipmetallisierung (24₁) näher an einer dritten Seite (3₂₄) des ersten Halbleiter-Dies (24) als an einer vierten Seite (4₂₄) des ersten Halbleiter-Dies (24) gegenüber der dritten Seite (3₂₄) angeordnet ist,
die zweite Chipmetallisierung (24₂) auf einer zweiten Hälfte des ersten Halbleiter-Dies (24) angeordnet ist, sich zwischen der ersten Seite und der zweiten Seite des ersten Halbleiter-Dies (24) erstreckt und näher an der vierten Seite als an der dritten Seite des ersten Halbleiter-Dies (24) angeordnet ist,
die zweite Chipmetallisierung (24₂) kleiner als die erste Chipmetallisierung (24₁) ist und näher an der ersten Seite als an der zweiten Seite des ersten Halbleiter-Dies (24) angeordnet ist, wodurch eine Ecke des ersten Halbleiter-Dies (24), die zwischen der zweiten Seite (2₂₄) und der vierten Seite (4₂₄) des ersten Halbleiter-Dies (24) gebildet ist, innerhalb der dritten Chipmetallisierung (24₃) entweder durch die erste Chipmetallisierung (24₁) oder die zweite Chipmetallisierung (24₂) oder durch eine beliebige andere Metallisierung unbedeckt gelassen wird, das erste Muster des mindestens einen ersten Halbleiter-Dies (24) spiegelsymmetrisch zu dem zweiten Muster des mindestens einen zweiten Halbleiter-Dies (26) in Bezug auf eine Symmetrieachse (Y) ist, und
das erste Muster und das zweite Muster nicht überlagerbar sind und nicht exakt aufeinander ausgerichtet werden können.

2. Leistungshalbleitermodulanordnung (200) nach Anspruch 1, wobei
jeder des mindestens einen ersten Halbleiter-Dies (24) einen Lastpfad zwischen einem ersten Lastanschluss und einem zweiten Lastanschluss und einem Steueranschluss umfasst, wobei der zweite Lastanschluss jedes des mindestens einen ersten Halbleiter-Dies (24) mit der jeweiligen ersten Chipmetallisierung (24₁) verbunden ist und der Steueranschluss jedes des mindestens einen ersten Halbleiter-Dies (24) mit der jeweiligen zweiten Chipmetallisierung (24₂) verbunden ist, und
jeder der mindestens einen zweiten Halbleiter-Dies (26) einen Lastpfad zwischen einem ersten Lastanschluss und einem zweiten Lastanschluss und einem Steueranschluss umfasst, wobei der zweite Lastanschluss jedes der mindestens einen zweiten Halbleiter-Dies (26) mit der jeweiligen ersten Chipmetallisierung (26₁) verbunden ist und der Steueranschluss jedes des mindestens einen zweiten Halbleiter-Dies (26) mit der jeweiligen zweiten Chipmetallisierung (26₂) verbunden ist.

3. Leistungshalbleitermodulanordnung (200) nach Anspruch 1 oder 2, wobei die erste Metallisierungsschicht (111) eine strukturierte Schicht ist, die mehrere unterschiedliche Abschnitte (111ₓ) umfasst, wobei der mindestens eine erste Halbleiter-Die (24) auf einem ersten Abschnitt (111₁) der ersten Metallisierungsschicht (111) angeordnet ist und der mindestens eine zweite Halbleiter-Die (26) auf einem anderen Abschnitt (111₇) der ersten Metallisierungsschicht (111) angeordnet ist.

4. Leistungshalbleitermodulanordnung (200) nach Anspruch 3, wobei
die ersten Chipmetallisierungen (24₁) jedes des mindestens einen ersten Halbleiter-Dies (24) mittels mindestens einer elektrischen Verbindung (3) elektrisch mit einem zweiten Abschnitt (111₂) der ersten Metallisierungsschicht (111) gekoppelt sind,
die zweiten Chipmetallisierungen (242) jedes des mindestens einen ersten Halbleiter-Dies (24) mittels mindestens einer elektrischen Verbindung (3) elektrisch mit einem dritten Abschnitt (111₃) der ersten Metallisierungsschicht (111) gekoppelt sind.

5. Leistungshalbleitermodulanordnung (200) nach Anspruch 4, wobei jede der mindestens einen elektrischen Verbindung (3) einen Bonddraht oder ein Bondband umfasst.

6. Leistungshalbleitermodulanordnung (200) nach einem der Ansprüche 1 bis 5, wobei jeder der ersten Halbleiter-Dies (24) und jeder der zweiten Halbleiter-Dies (26) einen Bipolartransistor mit isoliertem Gate, IGBT, einen Metalloxid-Halbleiter-Feldeffekttransistor, MOSFET, einen Sperrschicht-Feldeffekttransistor, JFET oder einen Transistor mit hoher Elektronenbeweglichkeit, HEMT, umfasst.

7. Leistungshalbleitermodulanordnung (200) nach einem der vorhergehenden Ansprüche, wobei
jeder des mindestens einen ersten Halbleiter-Dies (24) und jeder des mindestens einen zweiten Halbleiter-Dies (26) mehrere einzelne Transistorzellen umfasst, die in einem Halbleiterkörper des jeweiligen ersten oder zweiten Halbleiter-Dies (24, 26) gebildet sind, wobei jede einzelne Transistorzelle eine Gate-Elektrode umfasst, jeder des mindestens einen ersten Halbleiter-Dies (24) und jeder des mindestens einen zweiten Halbleiter-Dies (26) ferner eine Gate-Zuleitung (24₄, 26₄) umfasst, die die mehreren Gate-Elektroden elektrisch mit der jeweiligen zweiten Chipmetallisierung (24₂, 26₂) koppelt, die Gate-Zuleitung (24₄, 26₄) ein umlaufendes Metallisierungsgebiet ist, das sich entlang der vier verschiedenen Seiten des jeweiligen ersten oder zweiten Halbleiter-Dies (24, 26) erstreckt, und
die jeweilige dritte Chipmetallisierung (24₃, 26₃) zwischen der Gate-Zuleitung (24₄, 26₄) und den Kanten des jeweiligen ersten oder zweiten Halbleiter-Dies (24, 26) angeordnet ist.

8. Leistungshalbleitermodulanordnung (200) nach Anspruch 7, wobei sowohl jeder des mindestens einen ersten Halbleiter-Dies (24) als auch jeder des mindestens einen zweiten Halbleiter-Dies (26) ferner mindestens einen Gate-Finger (24₄₂, 26₄₂) umfasst, der auf der oberen Oberfläche des jeweiligen ersten oder zweiten Halbleiter-Dies (24, 26) angeordnet ist, wobei der mindestens eine Gate-Finger (24₄₂, 26₄₂) dazu ausgelegt ist, ein Steuersignal gleichmäßiger auf die einzelnen Transistorzellen des jeweiligen ersten oder zweiten Halbleiter-Dies (24, 26) zu verteilen.

9. Leistungshalbleitermodulanordnung (200) nach Anspruch 8, wobei jede der mindestens einen umlaufenden Gate-Zuleitung (24₄, 26₄) eine im Wesentlichen quadratische oder rechteckige Form aufweist und wobei sich jeder des mindestens einen Gate-Fingers (24₄₂, 26₄₂) kontinuierlich zwischen zwei gegenüberliegenden Seiten der Gate-Zuleitung (24₄, 26₄) erstreckt.

10. Leistungshalbleitermodulanordnung (200) nach Anspruch 8, wobei jede der mindestens einen umlaufenden Gate-Zuleitung (24₄, 26₄) eine im Wesentlichen quadratische oder rechteckige Form aufweist und wobei jeder des mindestens einen Gate-Fingers (24₄₂, 26₄₂) nur mit einer Seite der Gate-Zuleitung (24₄, 26₄), aber nicht mit der gegenüberliegenden Seite der Gate-Zuleitung (24₄, 26₄) in Kontakt kommt.

## Revendications

1. Un agencement (200) de module de semiconducteur de puissance comprenant :
un substrat (10) comprenant une couche (11) diélectrique isolante et une première couche (111) de métallisation disposée sur un premier côté de la couche (11) diélectrique isolante ;
au moins une première puce (24) à semiconducteur, mise en œuvre comme dispositif de commutation et montée sur la première couche (111) de métallisation du substrat (10) ; et
au moins une deuxième puce (26) à semiconducteur, mise en œuvre comme dispositif de commutation et montée sur la première couche (111) de métallisation du substrat (10), dans lequel
chacune de la au moins une première puce (24) à semiconducteur comprend une première métallisation (24₁) de puce, une deuxième métallisation (24₂) de puce et une troisième métallisation (24₃) disposées sur une face de sommet de la première puce (24) à semiconducteur respective, dans lequel une face du sommet de la première puce (24) à semiconducteur est une face de la première puce (24) à semiconducteur, qui est en face loin du substrat (10),
chacune de la au moins une deuxième puce (26) à semiconducteur comprend une première métallisation (26₁) de puce, une deuxième métallisation (26₂) de puce et une troisième métallisation (26₃) de puce disposées sur une face de sommet de la deuxième puce (26) à semiconducteur respective, dans lequel une face du sommet de la deuxième puce (26) à semiconducteur est une face de la deuxième (26) à semiconducteur, qui est en face loin du substrat (10),
la première métallisation (24₁) de puce, la deuxième métallisation (24₂) de puce et la troisième métallisation (24₃) de puce de chacune de la au moins une première puce (24) à semiconducteur forment une première configuration sur la face de sommet de la première puce (24) à semiconducteur respective,
la première métallisation (26₁) de puce, la deuxième métallisation (26₂) de puce et la troisième métallisation (26₃) de puce de chacune de la au moins une deuxième puce (26) à semiconducteur forment une deuxième configuration sur la face de sommet de la deuxième puce (26) à semiconducteur respective, la deuxième configuration étant différente de la première configuration,
la première configuration et la deuxième configuration sont des configurations chirales,
la première métallisation (24₁) de puce et la deuxième métallisation (24₂) de puce de la au moins une première puce (24) à semiconducteur sont des métallisations extensives, qui sont rectangulaires en vue de dessus,
et la troisième métallisation (24₃) de puce de la au moins une première puce (24) à semiconducteur est une métallisation circonférentielle s'étendant suivant un bord de la première puce (24) à semiconducteur respective,
la première métallisation (26₁) de puce et la deuxième métallisation (26₂) de la au moins une deuxième puce (26) à semiconducteur sont des métallisations extensives, qui sont rectangulaires en vue de dessus,
et la troisième métallisation (26₃) de puce de la au moins une deuxième puce (26) à semiconducteur est une métallisation circonférentielle s'étendant suivant un bord de la deuxième puce (26) à semiconducteur respective,
la troisième métallisation (24₃) de puce de chacune de la au moins une première puce (24) à semiconducteur forme une électrode à plaque de champ de terminaison,
la troisième métallisation (26₃) de puce de chacune de la au moins une deuxième puce (26) à semiconducteur forme une électrode à plaque de champ de terminaison,
chacune de la au moins une première puce (24) à semiconducteur est carrée ou rectangulaire en vue de dessus,
la troisième métallisation (24₃) de puce est une métallisation circonférentielle s'étendant d'une manière continue le long de tous les quatre bords de la première puce (24) à semiconducteur respective,
la première métallisation (24₁) de puce est disposée sur une première moitié de la première puce (24) à semiconducteur, c'est entre un premier côté (1₂₄) de la première puce (24) à semiconducteur et un deuxième côté (2₂₄) de la première puce (24) à semiconducteur opposé au premier côté (1₂₄),
la première métallisation (24₁) de puce est disposée plus près d'un troisième côté (3₂₄) de la première puce (24) à semiconducteur que d'un quatrième côté (4₂₄) de la première puce (24) à semiconducteur opposé au troisième côté (3₂₄),
la deuxième métallisation (24₂) de puce est disposée sur une deuxième moitié de la première puce (24) à semiconducteur, en s'étendant entre le premier côté et le deuxième côté de la première puce (24) à semiconducteur et en étant disposée plus près du quatrième côté que du troisième côté de la première puce (24) à semiconducteur,
la deuxième métallisation (24₂) de puce est plus petite que la première métallisation (24₁) de puce et est disposée plus près du premier côté que du deuxième côté de la première puce (24) à semiconducteur en laissant un coin de la première puce (24) à semiconducteur formé entre le deuxième côté (2₂₄) et le quatrième côté (4₂₄) de la première puce (24) à semiconducteur à l'intérieur de la troisième métallisation (24₃) de puce non recouverte, soit par la première métallisation (24₁) de puce, soit par la deuxième métallisation (24₂) de puce, soit par toute autre métallisation,
la première configuration de la au moins une première puce (24) à semiconducteur est symétrique comme en un miroir de la deuxième configuration de la au moins une deuxième puce (26) à semiconducteur par rapport à un axe (Y) de symétrie, et
la première configuration et la deuxième configuration ne sont pas superposables et ne peuvent pas être alignées exactement l'une sur l'autre.

2. L'agencement (200) de module de semiconducteur de puissance de la revendication 1, dans lequel
chacune de la au moins une première puce (24) à semiconducteur comprend un chemin de charge entre une première borne de charge et une deuxième borne de charge, et une borne de commande, dans lequel la deuxième borne de charge de chacune des au moins une première puce (24) à semiconducteur est connectée à la première métallisation (24₁) de puce respective et la borne de commande de chacune de la au moins une première puce (24) à semiconducteur est connectée à la deuxième métallisation (24₂) de puce respective, et
chacune de la au moins une deuxième puce (26) à semiconducteur comprend un chemin de charge entre une première borne de charge et une deuxième borne de charge et une borne de commande, dans lequel la deuxième borne de charge de chacune de la au moins une deuxième puce (26) à semiconducteur est connectée à la première métallisation (26₁) de puce respective et la borne de commande de chacune de la au moins une deuxième puce (26) à semiconducteur est connectée à la deuxième métallisation (26₂) de puce respective.

3. L'agencement (200) de module de semiconducteur de puissance de la revendication 1 ou 2, dans lequel la première couche (111) de métallisation est une couche structurée comprenant une pluralité de parties (111ₓ) différentes, dans lequel la au moins une première puce (24) à semiconducteur est disposée sur une première partie (111₁) de la première couche (111) de métallisation et la au moins une deuxième puce (26) à semiconducteur est disposée sur une autre partie (111₇) de la première couche (111) de métallisation.

4. L'agencement (200) de module de semiconducteur de puissance de la revendication 3, dans lequel
les premières métallisations (24₁) de puce de chacune de la au moins une première puce (24) à semiconducteur sont connectées électriquement à une deuxième partie (111₂) de la première couche (111) de métallisation au moyen d'au moins une connexion (3) électrique,
les deuxièmes métallisations (24₂) de puce de chacune de la au moins une première puce (24) à semiconducteur sont connectées électriquement à une troisième partie (111₃) de la première couche (111) de métallisation au moyen d'au moins une connexion (3) électrique.

5. L'agencement (200) de module de semiconducteur de puissance de la revendication 4, dans lequel chacune de la au moins une connexion (3) électrique comprend un fil de liaison ou un ruban de liaison.

6. L'agencement (200) de module de semiconducteur de puissance de l'une quelconque des revendications 1 à 5, dans lequel chacune des premières puces (24) à semiconducteur et chacune des deuxièmes puces (26) à semiconducteur comprend un transistor bipolaire à grille isolée, IGBT, un transistor à effet de champ oxyde-métal-semiconducteur, MOSFET, un transistor à effet de champ de jonction, JFET, ou un transistor à grande mobilité des électrons, HEMT.

7. L'agencement (200) de module de semiconducteur de puissance de l'une quelconque des revendications précédentes, dans lequel
chacune de la au moins une première puce (24) à semiconducteur et chacune de la au moins une deuxième puce (26) à semiconducteur comprend une pluralité de cellules individuelles de transistor formées dans un corps semiconducteur de la première ou de la deuxième puce (24, 26) à semiconducteur respective, dans lequel chaque cellule individuelle de transistor comprend une électrode de grille,
chacune de la au moins une première puce (24) à semiconducteur et chacune de la au moins une deuxième puce (26) à semiconducteur, comprend en outre, un canal (24₄, 26₄) de grille, qui connecte électriquement la pluralité d'électrodes de grille à la deuxième métallisation (24₂, 26₂) de puce respective,
le canal (24₄, 26₄) de grille est une région circonférentielle de métallisation s'étendant sur les quatre côtés différents de la première ou de la deuxième puce (24, 26) à semiconducteur respective, et
la troisième métallisation (24₃, 26₃) de puce respective est disposée entre le canal (24₄, 26₄) de grille et les bornes de la première ou de la deuxième puce (24, 26) à semiconducteur respective.

8. L'agencement (200) de module de semiconducteur de puissance de la revendication 7, dans lequel chacune de la au moins une première puce (24) à semiconducteur et chacune de la au moins une deuxième puce (26) à semiconducteur, comprend en outre, au moins un doigt (24₄₂, 26₄₂) de grille disposé sur une surface de sommet de la première ou de la deuxième puce (24, 26) à semiconducteur respective, dans lequel le au moins un doigt (24₄₂, 26₄₂) de grille est configuré pour répartir plus uniformément un signal de commande aux cellules individuelles de transistor de la première ou de la deuxième puce (24, 26) à semiconducteur respective.

9. L'agencement (200) de module de semiconducteur de puissance de la revendication 8, dans lequel chacun du au moins un canal (24₄, 26₄) circonférentiel de grille a une forme sensiblement carrée ou rectangulaire, et dans lequel chacun du au moins un doigt (24₄₂, 26₄₂) de grille s'étend de manière continue entre deux côtés opposés du canal (24₄, 26₄) de grille.

10. L'agencement (200) de module de semiconducteur de puissance de la revendication 8, dans lequel chacun du au moins un canal (24₄, 26₄) circonférentiel de grille a une forme sensiblement carrée ou rectangulaire, et dans lequel chacun du au moins un doigt (24₄₂, 26₄₂) de grille est en contact avec seulement un côté du canal (24₄, 26₄) de grille, mais non avec le côté opposé du canal (24₄, 26₄) de grille.
